# EUROPEAN PATENT APPLICATION

(11) **EP 4 571 026 A1**
(43) Date of publication of application: **18.06.2025**
(21) Application number: 23914169.0
(22) Date of filing: 03.04.2023
(51) Int. Cl.: E05C 9/04, E05C 9/12, E05C 9/18, E05B 15/10, H02B 1/30

(54) **CONNECTING ASSEMBLY, ENERGY STORAGE CABINET AND ENERGY STORAGE SYSTEM**

(30) Priority: 04.01.2023 CN 202320008710 U
(71) Applicant: Contemporary Amperex Technology (Hong Kong) Limited, Central (HK)
(72) Inventor: ZHOU, Xinhua, Ningde, Fujian 352100 (CN); WANG, Zengzhong, Ningde, Fujian 352100 (CN); PENG, Haoran, Ningde, Fujian 352100 (CN); SU, Haibin, Ningde, Fujian 352100 (CN)
(74) Representative: Kraus & Lederer PartGmbB
(86) International application number: PCT/CN2023/085883
(87) International publication number: WO 2024/146017

(57) **Abstract**

A connection assembly, an energy storage cabinet, and an energy storage system are disclosed. When the cabinet is closed, a locking piece (30) is connected between a first limiting piece (10) and a second limiting piece (20), so as to connect a door (200) and a cabinet body (300). When the door (200) is impacted, the locking piece (30) connects the door (200) and the cabinet body (300), thereby improving stability of connection between the door (200) and the cabinet body (300).

## Description

### CROSS-REFERENCE TO RELATED APPLICATIONS

This application references Chinese Patent Application No. 202320008710.3, filed on January 4, 2023 and entitled "CONNECTION ASSEMBLY, ENERGY STORAGE CABINET, AND ENERGY STORAGE SYSTEM", which is incorporated herein by reference in its entirety.

### TECHNICAL FIELD

This application relates to the technical field of cabinet structures, and in particular, to a connection assembly, an energy storage cabinet, and an energy storage system.

### BACKGROUND

Currently, when an impact force is generated inside a cabinet, the impact force is usually transmitted to a connection assembly between a door and a cabinet body first, and then transmitted inside the connection assembly, and finally transmitted to the door. Therefore, the transmission path of the impact force is long, thereby imposing a high requirement on the strength of the connection assembly.

### SUMMARY

In view of the facts above, it is necessary to provide a connection assembly, an energy storage cabinet, and an energy storage system to solve the problem that a high requirement is imposed on the strength of a connection assembly due to a long transmission path of an impact force.

According to a first aspect, this application provides a connection assembly. The connection assembly is configured to implement connection to open or close a cabinet. The cabinet includes a cabinet body and a door. The connection assembly includes:
a first limiting piece, fixed onto the door;
a second limiting piece, fixed onto the cabinet body, where the second limiting piece is disposed opposite to the first limiting piece; and
a locking piece, where the locking piece is configured to be fitted into the first limiting piece and the second limiting piece when the cabinet is closed.

In the technical solution in this embodiment of this application, the first limiting piece and the second limiting piece are disposed on the door and the cabinet body respectively, and a locking piece is disposed, so that the locking piece can be fitted into the first limiting piece and the second limiting piece when the cabinet is closed. On the one hand, this arrangement enables smooth opening and closing of the door for the cabinet body. On the other hand, the locking piece can transfer the received impact force to the door directly, thereby shortening the transmission path of the force, and reducing the requirement on the strength of the connection assembly.

In some embodiments, a first locking position is created on the first limiting piece, and a second locking position is created on the second limiting piece. When the cabinet is closed, the locking piece fits into the first locking position and the second locking position.

In the technical solution in these embodiments of this application, the locking piece is locked in the first locking position and the second locking position respectively, so as to implement stable connection between the door and the cabinet body and ensure that the cabinet is stably closed.

In some embodiments, the first locking position is configured to be a first groove, and/or the second locking position is configured to be a second groove.

In the technical solution in these embodiments of this application, the first groove or the second groove can quickly implement the connection between the locking piece and the first limiting piece or the second limiting piece.

In some embodiments, the first locking position is configured to be the first groove, the second locking position is configured to be the second groove, and the second groove and the first groove open in a same direction.

In the technical solution in these embodiments of this application, the first groove and the second groove can jointly implement the connection between the locking piece and the first limiting piece as well as the connection between the locking piece and the second limiting piece, and make the connection assembly simpler.

In some embodiments, two first grooves are provided, and openings of the two first grooves are opposite to each other in a height direction of the cabinet.

In the technical solution in these embodiments of this application, when the locking piece is snap-fitted in the first grooves, the two first grooves opened opposite to each other can coordinate with each other to ensure stable positioning of the locking piece in the first grooves.

In some embodiments, two second grooves are provided. Openings of the two second grooves are opposite to each other in a height direction of the cabinet.

In the technical solution in these embodiments of this application, the second groove coordinates with the first groove. Therefore, the two second grooves are also opened opposite to each other in the height direction of the cabinet. In this way, the locking piece can be simultaneously snap-fitted in the first groove and the second groove, thereby improving the stability of positioning of the locking piece in the first groove and the second groove.

In some embodiments, a plurality of the first limiting pieces are provided. The first groove is created on each first limiting piece, and openings of at least two of the first grooves are opposite to each other in a height direction of the cabinet.

In the technical solution in these embodiments of this application, when the locking piece is snap-fitted in the first grooves, the two first grooves opened opposite to each other can coordinate with each other to ensure stable positioning of the locking piece in the first grooves.

In some embodiments, a plurality of the second limiting pieces are provided. The second groove is created on each second limiting piece, and openings of at least two of the second grooves are opposite to each other in a height direction of the cabinet.

In the technical solution in these embodiments of this application, the second groove coordinates with the first groove. Therefore, the two second grooves are also opened opposite to each other in the height direction of the cabinet. In this way, the locking piece can be simultaneously snap-fitted in the first groove and the second groove, thereby improving the stability of positioning of the locking piece in the first groove and the second groove.

In some embodiments, the connection assembly includes a connecting rod assembly extending along a height direction of the cabinet, and the connecting rod assembly is configured to connect the door and the first limiting piece.

In the technical solution in these embodiments of this application, the structure is simple and facilitates operation, and enables smooth connection between the door and the cabinet body. In addition, the connecting rod assembly can provide a mounting base for the locking piece. When the connecting rod assembly moves along the extension direction of the connecting rod assembly, the connecting rod assembly can drive the locking piece thereon to move synchronously, so as to drive the locking piece to enter or exit the first groove and the second groove, and in turn, implement the locking smoothly.

In some embodiments, the connecting rod assembly includes a connecting rod base and two connecting rod pieces disposed on the door. The two connecting rod pieces are connected to two opposite sides of the connecting rod base respectively along the height direction of the cabinet. The connecting rod base is configured to drive the two connecting rod pieces to move closer to or away from each other.

In the technical solution in these embodiments of this application, two connecting rod pieces are provided, thereby further shortening the transmission path of the impact force on the connecting rod assembly and reducing the requirement on the strength of the connecting rod assembly on the one hand. On the other hand, in the extension direction of the connecting rod assembly, the two connecting rod pieces can move in opposite directions, so as to move closer to or away from each other as driven by the connecting rod base, and in turn, open and close the door more smoothly.

In some embodiments, a plurality of the first limiting pieces are provided. A first groove is created on each first limiting piece.

The first grooves on the first limiting pieces located on the same side of the connecting rod base along the height direction of the cabinet open in a same direction. All the first grooves open toward the connecting rod base.

In the technical solution in these embodiments of this application, when the cabinet is closed, the connecting rod base can drive the two connecting rod pieces to move closer to or away from each other. The locking piece moves synchronously with the two connecting rod pieces, so as to smoothly enter or exit the corresponding first groove.

In some embodiments, a plurality of the second limiting pieces are provided, and a second groove is created on each second limiting piece.

The second grooves on the second limiting pieces located on the same side of the connecting rod base along the height direction of the cabinet open in a same direction. All the second grooves open toward the connecting rod base.

In the technical solution in these embodiments of this application, when the cabinet is closed, the connecting rod base can drive the two connecting rod pieces to move closer to or away from each other. The locking piece moves synchronously with the two connecting rod pieces, so as to smoothly enter or exit the corresponding second groove.

In some embodiments, the locking piece is a limiting pin. The limiting pin is disposed protrusively on the connecting rod piece, and the limiting pin intersects the connecting rod piece.

In the technical solution in these embodiments of this application, the above structure can implement stable locking of the locking piece to the first groove and the second groove.

In some embodiments, the connection assembly further includes a bracket fixed onto the door. The connecting rod piece penetrates and fits into the bracket.

In the technical solution in these embodiments of this application, by providing a bracket, this application can increase connection points between the connecting rod and the door, and make the connection more stable between the connecting rod and the door.

In some embodiments, the connection assembly further includes a slide piece disposed on the connecting rod assembly and a mating piece disposed on the door. When the connecting rod assembly moves along an extension direction of the connecting rod assembly, the slide piece is able to slide into or out of the mating piece.

In the technical solution in these embodiments of this application, by disposing the slide piece and the mating piece that mate with each other, this application makes the cabinet closing process smoother. When the slide piece slides into the mating piece, this application reduces the collision between the door and the cabinet body, thereby exerting a protective effect.

In some embodiments, the slide piece is configured to be a pulley, and the mating piece is configured to be a slot that mates with the pulley.

In the technical solution in these embodiments of this application, by disposing the pulley and slot that mate with each other, on the one hand, when the pulley slides into the slot, the door can be locked to the cabinet body, thereby increasing the strength of locking between the door and the cabinet. On the other hand, the sliding fit between the pulley and the slot makes the cabinet closing process smoother.

In some embodiments, at least a part of a wall of the slot is configured to be a guide surface. The guide surface is configured to guide the pulley to slide into or out of the slot.

In the technical solution in these embodiments of this application, through the above structure, the pulley can fit the slot smoothly, thereby making the opening and closing of the cabinet smoother.

In some embodiments, the connection assembly further includes a latch disposed on the door and a latch bracket disposed on the cabinet body and mated to the latch. When the cabinet body is closed by the door, the latch is connected to the latch bracket.

In the technical solution in these embodiments of this application, the latch and the latch bracket can work together with the locking piece to implement locking between the door and the cabinet body, thereby improving the stability of connection between the door and the cabinet body.

According to a second aspect, this application provides an energy storage cabinet, including:
a cabinet body;
a door, rotatably disposed on the cabinet; and
the connection assembly disclosed above, where the connection assembly is connected between the door and the cabinet body.

According to a third aspect, this application provides an energy storage system, including a battery, a control device, and the energy storage cabinet disclosed above. The battery is accommodated in the energy storage cabinet. The control device is electrically connected to the battery.

With the connection assembly, the energy storage cabinet, and the energy storage system disclosed above, when the cabinet is closed, the locking piece is connected between the first limiting piece and the second limiting piece, so as to connect the door and the cabinet body. When the door is impacted, the locking piece can serve a function of connecting the door and the cabinet body, thereby effectively improving the stability of connection between the door and the cabinet body.

The foregoing description is merely an overview of the technical solutions of this application. Some specific embodiments of this application are described below illustratively to enable a clearer understanding of the technical solutions of this application, enable implementation of the technical solutions based on the subject-matter hereof, and make the foregoing and other objectives, features, and advantages of this application more evident and comprehensible.

### BRIEF DESCRIPTION OF DRAWINGS

By reading the following detailed description of embodiments, a person of ordinary skill in the art becomes clearly aware of various other advantages and benefits. The drawings are merely intended to illustrate the embodiments, but not to limit this application. In all the drawings, the same reference numeral represents the same component. In the drawings:
FIG. 1 is an overall schematic diagram of a connection assembly according to some embodiments of this application;
FIG. 2 is a close-up view of a part B shown in FIG. 1;
FIG. 3 is a close-up view of a part A shown in FIG. 1;
FIG. 4 is a schematic diagram of a partial region of a connection assembly according to some embodiments of this application;
FIG. 5 is a schematic diagram of a partial region of a connection assembly according to some embodiments of this application;
FIG. 6 is a schematic diagram of a partial region of a connection assembly according to some embodiments of this application;
FIG. 7 is a close-up view of a part D shown in FIG. 1;
FIG. 8 is a schematic diagram of a partial region of a connection assembly according to some embodiments of this application; and
FIG. 9 is a close-up view of a part C shown in FIG. 1.

List of reference numerals: 100. connection assembly; 200. door; 300. cabinet body; 10. first limiting piece; 20. second limiting piece; 30. locking piece; 11. first locking position; 12. second locking position; 40. connecting rod assembly; 60. bracket; 70. slide piece; 80. mating piece; 41. connecting rod base; 42. connecting rod piece; 81. guide surface; 91. latch; 92. latch bracket; a. height direction of the cabinet.

### DETAILED DESCRIPTION OF EMBODIMENTS

Some embodiments of the technical solutions of this application are described in detail below with reference to the drawings. The following embodiments are merely intended as examples to describe the technical solutions of this application more clearly, but not intended to limit the protection scope of this application.

Unless otherwise defined, all technical and scientific terms used herein bear the same meanings as what is normally understood by a person skilled in the technical field of this application. The terms used herein are merely intended to describe specific embodiments but not to limit this application. The terms "include" and "contain" and any variations thereof used in the specification, claims, and brief description of drawings of this application are intended as non-exclusive inclusion.

In the description of some embodiments of this application, the technical terms "first" and "second" are merely intended to distinguish between different items but not intended to indicate or imply relative importance or implicitly specify the number of the indicated technical features, specific order, or order of precedence. In the description of some embodiments of this application, unless otherwise expressly specified, "a plurality of" means two or more.

Reference to an "embodiment" herein means that a specific feature, structure or characteristic described with reference to this embodiment may be included in at least one embodiment of this application. Reference to this term in different places in the specification does not necessarily represent the same embodiment, nor does it represent an independent or alternative embodiment in a mutually exclusive relationship with other embodiments. A person skilled in the art explicitly and implicitly understands that the embodiments described herein may be combined with other embodiments.

In the description of embodiments of this application, the term "and/or" merely indicates a relationship between related items, and represents three possible relationships. For example, "A and/or B" may represent the following three circumstances: A alone, both A and B, and B alone. In addition, the character "/" herein generally indicates an "or" relationship between the item preceding the character and the item following the character.

In the description of embodiments of this application, the term "a plurality of" means two or more (including two). Similarly, "a plurality of groups" means two or more groups (including two groups), and "a plurality of pieces" means two or more pieces (including two pieces).

In the description of embodiments of this application, a direction or a positional relationship indicated by the terms such as "center", "longitudinal", "transverse", "length", "width", "thickness", "up", "down", "before", "after", "left", "right", "vertical", "horizontal", "top", "bottom", "in", "out", "clockwise", "counterclockwise", "axial", "radial", and "circumferential" is a direction or positional relationship based on the illustration in the drawings, and is merely intended for ease or brevity of description of embodiments of this application, but not intended to indicate or imply that the indicated device or component is necessarily located in the specified direction or constructed or operated in the specified direction. Therefore, such terms are not to be understood as a limitation on embodiments of this application.

In the description of this application, unless otherwise expressly specified and defined, the technical terms such as "mount", "concatenate", "connect", and "fix" are generic in a broad sense, for example, mean a fixed connection, a detachable connection, or a one-piece configuration; or mean a mechanical connection or an electrical connection; or mean a direct connection or an indirect connection implemented through an intermediary; or mean internal communication between two components or interaction between two components. A person of ordinary skill in the art can understand the specific meanings of the terms in some embodiments of this application according to specific situations.

Currently, as can be seen from the market trend, the application of power batteries is increasingly extensive. Power batteries are not only used in energy storage power systems such as hydro, thermal, wind, and solar power stations, but also widely used in electric means of transport such as electric bicycles, electric motorcycles, and electric vehicles, and used in many other fields such as military equipment and aerospace. The market demand for power batteries keeps soaring with the expansion of the application fields of the power batteries.

Specifically, power batteries may break down into a variety of models and types depending on the usage scenario and the usage method. Among the batteries, an energy storage device is mainly designed to power large-scale electrical equipment. Due to characteristics of the energy storage device, a majority of energy storage devices do not need to move. Therefore, for a battery in an energy storage device, just the power density needs to be adjusted to suit the energy storage scenario, but typically, without imposing a direct requirement on the energy density of the battery in the energy storage device. For energy storage scenarios of power grid peak shaving, off-grid photovoltaic energy storage, or user-side electricity price difference between peak and valley periods, the energy storage battery is usually charged or discharged continuously for at least two hours. Therefore, a capacity-type battery with a charge-discharge rate less than or equal to 0.5C is applicable to such scenarios. For energy storage scenarios of power frequency regulation or smoothing fluctuations in renewable energy, the energy storage battery needs to be charged and discharged quickly in a period as short as seconds or minutes, and therefore, a power-type battery is applicable to with a charge-discharge rate greater than or equal to 2C is applicable to such scenarios.

Furthermore, the energy storage device mainly includes a cabinet and a plurality of batteries that are accommodated inside the cabinet. All the batteries are arranged inside the cabinet to form an integral structure, so as to supply power to an external electrical device.

In practical applications, the size of the cabinet may be adjusted depending on the number of batteries accommodated therein. The number of batteries depends on the power of the electrical device actually to be powered.

Currently, when a cabinet structure is in use, faults such as deflagration or arcing are prone to occur inside the cabinet. In this way, the impact force generated is applied to the cabinet and the cabinet door.

Currently, the impact force generated inside the cabinet is first transmitted to a connection assembly between the cabinet door and the cabinet body, and then transmitted inside the connection assembly, for example, transmitted to a connecting rod through a slide pin, and then transmitted to the cabinet door through the connecting rod. Therefore, the transmission path of the impact force is long, thereby imposing a high requirement on the strength of the connection assembly.

In view of the above situation, in order to solve the problem that the transmission path of the impact force inside the cabinet is relatively long on the connection assembly, and the long transmission path imposes a high requirement on the strength of the connection assembly, the applicant hereof has designed a connection assembly after in-depth research. The connection assembly is connected between a door and a cabinet body. When the cabinet is closed, a locking piece is snap-connected between a first limiting piece and a second limiting piece to implement connection between the door and the cabinet body. When the door is impacted, the impact force is transmitted to the first limiting piece and the second limiting piece through the locking piece, thereby absorbing and dispersing the impact force on the door, and in turn, reducing the requirement on the strength of the connection assembly.

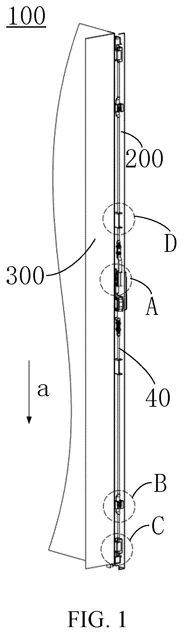

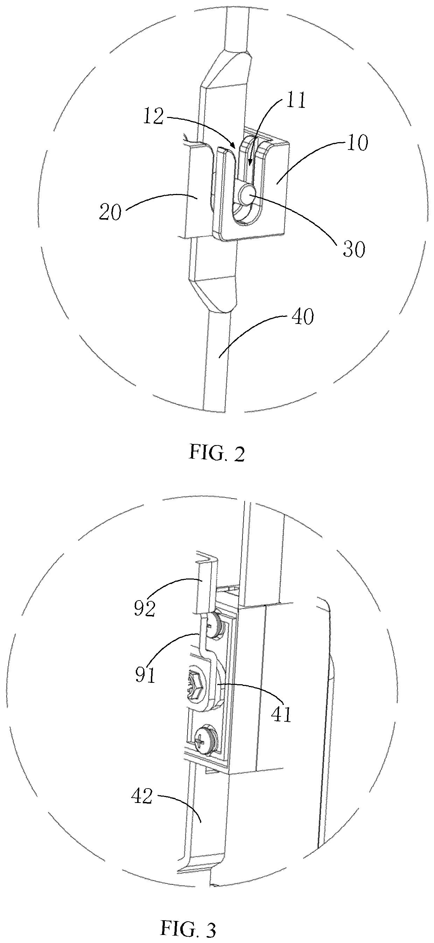

Referring to FIG. 1 and FIG. 2, an embodiment of this application provides a connection assembly 100. The connection assembly is configured to implement connection to open or close a cabinet. The cabinet includes a door 200 and a cabinet body 300. The connection assembly 100 includes a first limiting piece 10, a second limiting piece 20, and a locking piece 30. The first limiting piece 10 is fixed to the door 200. The second limiting piece 20 is fixed onto the cabinet body 300. The second limiting piece 20 is disposed opposite to the first limiting piece 10. The locking piece 30 is configured to be fitted into the first limiting piece 10 and the second limiting piece 20 when the cabinet is closed.

It is hereby noted that the connection assembly 100 means a component that is connected between the door 200 and the cabinet body 300 and that enables the door 200 to move relative to the cabinet body 300 to implement opening and closing.

Specifically, the first limiting piece 10 and the second limiting piece 20 are fixed to corresponding positions on the door 200 and the cabinet body 300 respectively. Both the first limiting piece 10 and the second limiting piece 20 can be connected to the locking piece 30.

When the cabinet is closed, the locking piece 30 is snap-connected between the first limiting piece 10 and the second limiting piece 20, and two opposite ends of the locking piece 30 are located in the first limiting piece 10 and the second limiting piece 20 respectively. At this time, the door 200 and the cabinet body 300 interlock through the locking piece 30 to prevent the door 200 from moving relative to the cabinet body 300.

When the door 200 is subjected to an impact force generated inside the cabinet, because the locking piece 30 is locked in the first limiting piece 10 and the second limiting piece 20 and the first limiting piece 10 is fixed to the door 200, the impact force is transmitted to the first limiting piece 10 and the second limiting piece 20 through the locking piece 30, thereby absorbing and dispersing the impact force on the door 200. Therefore, the locking piece 30 and the first limiting piece 10 and the second limiting piece 20 can directly absorb and disperse the impact force on the door 200, thereby improving the stability of connection between the door 200 and the cabinet body 300.

When the cabinet is opened, the locking piece 30 is detached from the first limiting piece 10 and the second limiting piece 20 separately, so that the door 200 can move relative to the cabinet body 300 to facilitate opening of the door.

The first limiting piece 10 and the second limiting piece 20 are disposed on the door 200 and the cabinet body 300 respectively, and the locking piece 30 is disposed, so that the locking piece 30 can be fitted into the first limiting piece 10 and the second limiting piece 20 when the cabinet is closed. On the one hand, this arrangement enables smooth opening and closing of the cabinet. On the other hand, the locking piece 30 can directly transfer the impact force received by the door 200 to the first limiting piece 10 and the second limiting piece 20, thereby reducing the requirement on the strength of the connection assembly 100, and improving the stability of connection between the door 200 and the cabinet body 300.

In some embodiments, a first locking position 11 is created on the first limiting piece 10, and a second locking position 12 is created on the second limiting piece 20. When the cabinet is closed, the locking piece 30 fits into the first locking position 11 and the second locking position 12.

Specifically, when the cabinet is closed, the two opposite ends of the locking piece 30 can be locked into the first locking position 11 and the second locking position 12 respectively, so as to implement stable connection between the door 200 and the cabinet body 300 and ensure that the cabinet is stably closed.

In some embodiments, the first locking position 11 is configured to be a first groove, and/or the second locking position 12 is configured to be a second groove. In this way, the first groove or the second groove can quickly implement the connection between the locking piece 30 and the first limiting piece 10.

In some embodiments, the first locking position 11 is configured to be the first groove, and the second locking position 12 is configured to be the second groove. The second groove and the first groove open in the same direction.

In this way, when the cabinet is closed, the locking piece 30 is snap-fitted into the first groove and the second groove. The first groove and the second groove enable the locking piece 30 to be quickly snap-connected between the first limiting piece 10 and the second limiting piece 20, thereby making the structure of the connection assembly 100 simpler.

Specifically, when the cabinet is closed, the first groove at least partially overlaps the second groove. The locking piece 30 can enter the first groove and the second groove from the openings of the first groove and the second groove respectively, and be snap-fitted into the first groove and the second groove. In this way, the locking between the door 200 and the cabinet body 300 is implemented by the locking piece 30.

When the cabinet needs to be opened, the locking piece 30 is detached from the first groove and the second groove first, and then the cabinet can be opened smoothly.

The first groove and the second groove can quickly implement the connection between the locking piece 30 and the first limiting piece 10 as well as the connection between the locking piece and the second limiting piece 20, and make the connection assembly 100 simpler.

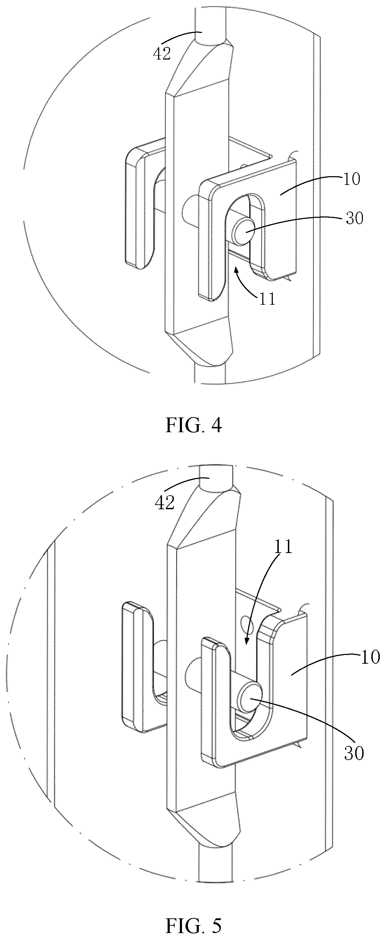

Referring to FIG. 1, FIG. 4, FIG. 5, and FIG. 6, in some embodiments, two first grooves are provided. The openings of the two first grooves are opposite to each other in a height direction of the cabinet.

In this way, when the locking piece 30 is snap-fitted in the first grooves, the two first grooves opened opposite to each other can coordinate with each other to ensure stable positioning of the locking piece 30 in the first grooves.

In some embodiments, two second grooves are provided. Openings of the two second grooves are opposite to each other in a height direction of the cabinet.

Specifically, the second groove coordinates with the first groove. Therefore, the two second grooves are also opened opposite to each other in the height direction of the cabinet. In this way, the locking piece 30 can be snap-fitted in the first groove and the second groove simultaneously, thereby improving the stability of positioning of the locking piece 30 in the first groove and the second groove.

In some embodiments, a plurality of the first limiting pieces 10 are provided. The first groove is created on each first limiting piece 10, and openings of at least two of the first grooves are opposite to each other in a height direction of the cabinet.

Specifically, two first limiting pieces 10 may be provided, so that two first grooves are provided. The openings of the two first grooves are opposite to each other along the height direction of the cabinet. In this case, when the cabinet is closed, each locking piece 30 is snap-connected into the corresponding first groove upward or downward along the height direction of the cabinet. In addition, when the locking piece 30 is snap-fitted in the first grooves, the two first grooves opened opposite to each other can coordinate with each other to ensure stable positioning of the locking piece 30 in the first grooves.

Definitely, in some other embodiments, the number of first limiting pieces 10 may be three or more, so that the openings of at least two of the first grooves are opposite to each other along the height direction of the cabinet. In other words, the openings of some of the first grooves among the plurality of first grooves face downward, and the openings of the other first grooves face upward. When the cabinet is closed, each locking piece 30 is snap-connected into the corresponding first groove upward or downward along the height direction of the cabinet, so as to snap-connect the locking piece 30 into the first groove stably.

In some embodiments, a plurality of the second limiting pieces 20 are provided. The second groove is created on each second limiting piece 20, and openings of at least two of the second grooves are opposite to each other in a height direction of the cabinet.

Specifically, the second groove coordinates with the first groove. Therefore, two second limiting pieces 20 may be provided, so that two second grooves are provided. The openings of the two second grooves are opposite to each other along the height direction of the cabinet. In this case, when the cabinet is closed, the locking piece 30 can be snap-fitted in the first groove and the second groove simultaneously, thereby improving the stability of positioning of the locking piece 30 in the first groove and the second groove.

Definitely, in some other embodiments, the number of second limiting pieces 20 may be three or more, so that the openings of at least two of the second grooves are opposite to each other along the height direction of the cabinet. In other words, the openings of some of the second grooves among the plurality of second grooves face downward, and the openings of the other second grooves face upward. When the cabinet is closed, each locking piece 30 is snap-connected into the corresponding second groove upward or downward along the height direction of the cabinet, so as to snap-connect the locking piece 30 into the second groove stably.

Still referring to FIG. 1, in some embodiments, the connection assembly 100 includes a connecting rod assembly 40 extending along the height direction a of the cabinet. The connecting rod assembly 40 is configured to connect the door 200 and the first limiting piece 10.

The connecting rod assembly 40 can provide a mounting base for the locking piece 30. When the connecting rod assembly 40 moves along the extension direction of the connecting rod assembly, the connecting rod assembly can drive the locking piece 30 thereon to move synchronously, so as to drive the locking piece 30 to enter or exit the first groove and the second groove, and in turn, implement the locking smoothly.

Referring to FIG. 1 and FIG. 3, in some embodiments, the connecting rod assembly 40 includes a connecting rod base 41 and two connecting rod pieces 42 disposed on the door 200. The two connecting rod pieces 42 are connected to two opposite sides of the connecting rod base 41 respectively along the height direction of the cabinet. The connecting rod base 41 is configured to drive the two connecting rod pieces 42 to move closer to or away from each other.

With the two connecting rod pieces 42 located on the two opposite sides of the connecting rod base 41 along the height direction a of the cabinet, the two connecting rod pieces 42 can shorten the transmission path of the impact force on the connecting rod assembly 40 and further reduce the requirement on the strength of the connecting rod assembly 40 on the one hand. On the other hand, in the extension direction of the connecting rod assembly 40, the two connecting rod pieces 42 can move in opposite directions, so as to move closer to or away from each other as driven by the connecting rod base 41, and in turn, open and close the cabinet door more smoothly.

Furthermore, when the connecting rod base 41 drives the two connecting rod pieces 42 to move closer to or away from each other, the locking pieces 30 on the two connecting rod pieces 42 can enter or exit the first groove and the second groove, thereby implementing opening and closing of the cabinet door smoothly.

In this way, the two connecting rod pieces 42 can further shorten the transmission path of the impact force on the connecting rod assembly 40 and reduce the requirement on the strength of the connecting rod assembly 40 on the one hand. On the other hand, in the extension direction of the connecting rod assembly 40, the two connecting rod pieces 42 can move in opposite directions, so as to move closer to or away from each other as driven by the connecting rod base 41, and in turn, open and close the cabinet door more smoothly.

In a specific embodiment, a specific structure by which the connecting rod base 41 drives the two connecting rod pieces 42 to move closer to or away from each other can be: a gear (not shown in the drawing) is rotatably disposed on the connecting rod base 41, and correspondingly, a rack that meshes with the gear is disposed at a corresponding position on each of the two connecting rod pieces 42, so that the gear can be meshed with and connected to the two connecting rod pieces 42. In this way, when the gear rotates around its own axis as driven by an external force, the gear can drive the two connecting rod pieces 42 to move closer to or away from each other.

Furthermore, in an extension direction of the connecting rod pieces, the two connecting rod pieces 42 are located on two opposite sides of the gear respectively. In a direction perpendicular to the extension direction, the two connecting rod pieces 42 are also located on two opposite sides of the gear respectively. In this way, when the gear rotates, the two connecting rod pieces 42 can generate movement in opposite directions simultaneously, so that the two connecting rod pieces 42 move closer to or away from each other.

The meshing and connection between the gear and each of the two connecting rod pieces 42 can quickly implement synchronous movement of the two connecting rod pieces 42, and enable the two connecting rod pieces 42 to move closer to or away from each other. The structure is simple and facilitates operation.

In some embodiments, a plurality of the first limiting pieces 10 are provided. A first groove is created on each first limiting piece 10. The first grooves on the first limiting pieces 10 located on the same side of the connecting rod base 41 along the height direction of the cabinet open in the same direction. All the first grooves open toward the connecting rod base 41.

Specifically, the two connecting rod pieces 42 are connected to two opposite sides of the connecting rod base 41 respectively along the height direction of the cabinet. In other words, the two connecting rod pieces 42 may be regarded as an upper connecting rod and a lower connecting rod respectively. The connecting rod located above the connecting rod base 41 is the upper connecting rod, and the connecting rod located below the connecting rod base 41 is the lower connecting rod.

In actual operation, the connecting rod base 41 drives the upper connecting rod to move downward, and drives the lower connecting rod to move upward. Therefore, the first grooves created on the first limiting pieces 10 located on the same side as the upper connecting rod open downward, and the first grooves created on the first limiting pieces 10 located on the same side as the lower connecting rod open upward.

In this way, when the connecting rod base 41 drives the two connecting rod pieces 42 to move closer to each other, the locking pieces 30 on the connecting rod pieces 42 can enter or exit the first grooves smoothly.

In some embodiments, a plurality of the second limiting pieces 20 are provided, and a second groove is created on each second limiting piece 20. The second grooves on the second limiting pieces 20 located on the same side of the connecting rod base 41 along the height direction of the cabinet open in the same direction. All the second grooves open toward the connecting rod base 41.

Specifically, the connecting rod base 41 drives the upper connecting rod to move downward, and drives the lower connecting rod to move upward. Therefore, the second grooves created on the second limiting pieces 20 located on the same side as the upper connecting rod open downward, and the second grooves created on the second limiting pieces 20 located on the same side as the lower connecting rod open upward.

In this way, when the connecting rod base 41 drives the two connecting rod pieces 42 to move closer to each other, the locking pieces 30 on the connecting rod pieces 42 can enter or exit the second grooves smoothly.

Still referring to FIG. 2, FIG. 4, and FIG. 5, in some embodiments, the locking piece 30 is a limiting pin. The limiting pin is disposed protrusively on the connecting rod piece 42, and the limiting pin intersects the connecting rod 40. When the cabinet is closed, the limiting pin is snap-fitted into the first groove and/or the second groove along a radial direction of the limiting pin.

Specifically, the axial direction of the limiting pin is perpendicular to the extension direction of the connecting rod assembly 40. When the connecting rod assembly 40 moves along an extension direction of the connecting rod assembly, a locking piece 30 moves along with the connecting rod assembly 40, so that the locking piece 30 can be snap-fitted into the first groove and/or the second groove along a radial direction of the locking piece, so as to implement locking.

The above structure can implement stable locking of the locking piece 30 to the first groove and the second groove.

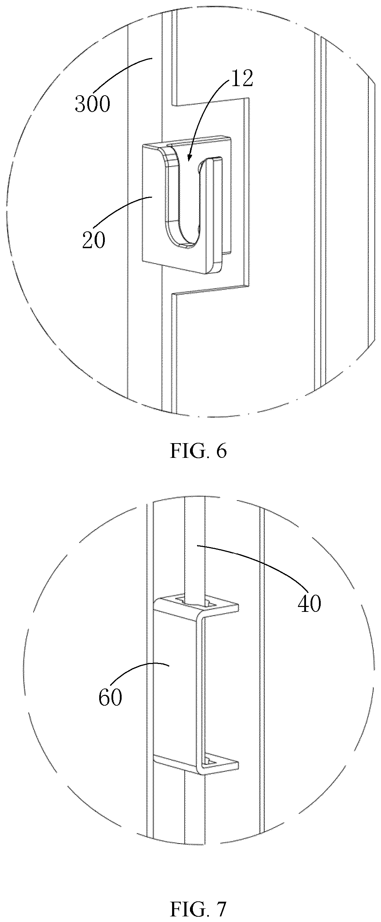

Referring to FIG. 7, in some embodiments, the connection assembly 100 further includes a bracket 60 fixed onto the door 200. The connecting rod piece 42 penetrates and fits into the bracket 60, and can move in the bracket 60 along the height direction a of the cabinet.

Specifically, a through-hole that penetrates the bracket along the height direction a of the cabinet is created on the bracket 60. The connecting rod piece 42 can run through the bracket 60 by way of the through-hole. In this way, the bracket 60 can constrain the connecting rod piece 42 along a direction perpendicular to the axial direction of the connecting rod assembly 40.

By providing the bracket 60, this application can increase position limiting points between the connecting rod piece 42 and the door 200, and make the connection more stable between the connecting rod piece 42 and the door 200.

In addition, at least two brackets 60 are disposed and spaced apart along the height direction a of the cabinet.

By increasing the number of the brackets 60, this application can further increase the connection points between the connecting rod piece 42 and the door 200, and further improve the stability of connection between the connecting rod piece 42 and the door 200.

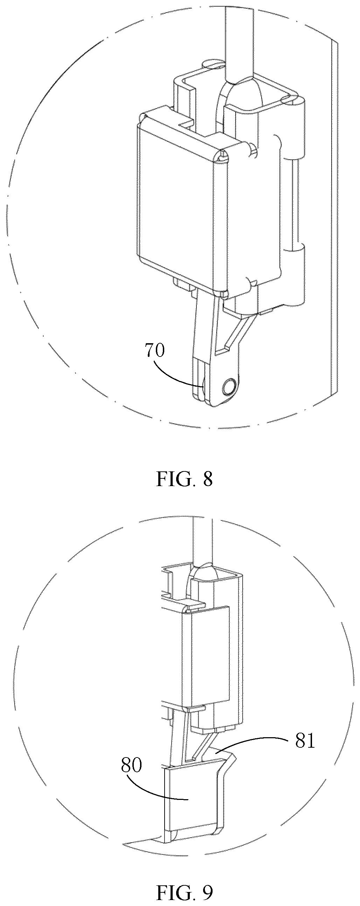

Referring to FIG. 1, FIG. 8, and FIG. 9, in some embodiments, the connection assembly 100 further includes a slide piece 70 disposed on the connecting rod assembly 40 and a mating piece 80 disposed on the door 200. When the connecting rod assembly 40 moves along an extension direction of the connecting rod assembly, the slide piece 70 is able to slide into or out of the mating piece 80.

When the cabinet is closed, the slide piece 70 slides into the mating piece 80 as driven by the connecting rod assembly 40, thereby implementing connection between the door 200 and the cabinet body 300. When the cabinet is opened, the slide piece 70 slides out of the mating piece 80 as driven by the connecting rod assembly 40.

By disposing the slide piece 70 and the mating piece 80 that mate with each other, this application makes it smoother to close the cabinet body 300 with the door 200. When the slide piece 70 slides into the mating piece 80, this application reduces the collision between the door 200 and the cabinet body 300, thereby exerting a protective effect.

In some embodiments, the slide piece 70 is configured to be a pulley, and the mating piece 80 is configured to be a slot that mates with the pulley.

By disposing the pulley and slot that mate with each other, on the one hand, when the pulley slides into the slot, the door 200 can be locked to the cabinet body 300, thereby increasing the strength of locking between the door and the cabinet. On the other hand, the sliding fit between the pulley and the slot makes it smoother to close the cabinet body 300 with the door 200.

In some embodiments, at least a part of a wall of the slot is configured to be a guide surface 81. The guide surface 81 is configured to guide the pulley to slide into the slot.

Specifically, a wall, facing the pulley, of the slot is configured to be a guide surface 81. When the cabinet is closed, when the two connecting rod pieces 42 move closer to or away from each other as driven by a gear, the pulley slides into or out of the slot under the guidance of the guide surface 81.

Through the above structure, the pulley can fit the slot smoothly, thereby making it smoother to open and close the cabinet body 300 with the door 200.

Still referring to FIG. 3, in some embodiments, the connection assembly 100 further includes a latch 91 disposed on the door 200 and a latch bracket 92 disposed on the cabinet body 300 and mated to the latch 91. When the cabinet body 300 is closed by the door 200, the latch 91 is snap-connected to the latch bracket 92.

Specifically, the latch 91 is disposed on a gear. When the gear rotates, the gear can drive the latch 91 to rotate synchronously. To close the cabinet, the latch 91 rotates as driven by the gear, so that the latch 91 is snap-fitted into the latch bracket 92, and the latch 91 is positioned in the latch bracket 92, thereby preventing the door 200 from detaching from the cabinet body 300. To open the cabinet, the latch 91 rotates as driven by a transmission gear, so as to detach from the latch bracket 92 and open the cabinet smoothly.

The latch 91 and the latch bracket 92 can work together with the locking piece 30 to implement locking between the door 200 and the cabinet body 300, thereby improving the stability of connection between the door 200 and the cabinet body 300.

Based on the same conception as the connection assembly 100, this application provides an energy storage cabinet, including a cabinet body 300, a door 200, and the connection assembly 100. The door 200 is rotatably disposed on the cabinet body 300. The connection assembly 100 is connected between the door 200 and the cabinet body 300.

In some embodiments, the connection assembly 100 includes two connecting rod pieces 42 extending along the height direction a of the cabinet. Two locking pieces 30 are provided, and are disposed on the two connecting rod pieces 42 respectively. Two first limiting pieces 10 are disposed opposite to each other along the height direction a of the cabinet, and correspond one-to-one to the two locking pieces 30. Two second limiting pieces 20 are disposed opposite to each other along the height direction a of the cabinet, and correspond one-to-one to the two locking pieces 30.

It is hereby noted that a first groove is created on each first limiting piece 10, and a second groove is created on each second limiting piece 20. In addition, the "two first limiting pieces 10 are disposed opposite to each other along the height direction a of the cabinet" means that the first grooves on the two first limiting pieces 10 open toward each other. The "two second limiting pieces 20 are disposed opposite to each other along the height direction a of the cabinet" means that the second grooves on the two second limiting pieces 20 open toward each other.

Specifically, the two connecting rod pieces are an upper connecting rod and a lower connecting rod respectively. Correspondingly, both first limiting pieces 10 are disposed on the door 200, and correspond to the upper connecting rod and the lower connecting rod respectively. The first groove on the first limiting piece 10 corresponding to the upper connecting rod opens downward, and the first groove on the first limiting piece 10 corresponding to the lower connecting rod opens upward.

Both second limiting pieces 20 are disposed on the cabinet body 300, and correspond to the upper connecting rod and the lower connecting rod respectively. The first groove on the second limiting piece 20 corresponding to the upper connecting rod opens downward, and the first groove on the second limiting piece 20 corresponding to the lower connecting rod opens downward.

To close the cabinet, the gear is rotated to drive the upper connecting rod to move upward and drive the lower connecting rod to move downward. The locking pieces 30 on the upper connecting rod and the lower connecting rod are snap-fitted into the corresponding first groove and second groove respectively to lock the cabinet.

To open the cabinet, the gear is rotated reversely to drive the upper connecting rod to move downward and drive the lower connecting rod to move upward. In this way, the locking pieces 30 on the upper connecting rod and the lower connecting rod are detached from the corresponding first groove and second groove respectively, thereby opening the cabinet smoothly.

Understandably, in some other embodiments, the locking piece 30 may be disposed on the upper connecting rod alone, or the locking piece 30 may be disposed on the lower connecting rod alone, thereby also implementing locking of the cabinet, the details of which are omitted here.

It is hereby noted that when the connection assembly 100 includes two connecting rod pieces 42, the pulleys may be a first pulley and a second pulley that correspond one-to-one to the two connecting rod pieces 42 respectively. Correspondingly, the slots may be a first slot and a second slot that fit the first pulley and the second pulley respectively. To close the cabinet, the two connecting rod pieces 42 move away from each other as driven by the gear, so that the first pulley and the second pulley slide into the first slot and the second slot respectively to lock the cabinet.

To open the cabinet, the two connecting rod pieces 42 move closer to each other as driven by the gear so that the first pulley and the second pulley are detached from the first slot and the second slot respectively to open the cabinet smoothly.

Based on the same conception as the energy storage cabinet, this application provides an energy storage system, including a battery, a control device, and the energy storage cabinet. The battery is accommodated in the energy storage cabinet. The control device is electrically connected to the battery.

In practical use of this application, if a cabinet needs to be closed, the gear on the door 200 is rotated first. The gear drives the upper connecting rod to move upward away from the lower connecting rod. The locking piece 30 on the upper connecting rod is snap-fitted upward into the corresponding first groove and second groove. At the same time, the first pulley on the upper connecting rod slides upward into the first slot.

Moreover, the gear drives the lower connecting rod to move downward away from the upper connecting rod. The locking piece 30 on the lower connecting rod is snap-fitted downward into the corresponding first groove and second groove. At the same time, the second pulley on the lower connecting rod slides downward into the second slot.

When the gear rotates, the gear drives the latch 91 to rotate, so that the latch 91 can be positioned in the latch bracket 92, thereby closing the cabinet. At this time, if an impact force is generated inside the cabinet, the impact force will be transmitted to the first limiting piece 10 through the locking piece 30, that is, directly transmitted to the door 200 through the locking piece 30, thereby shortening the transmission path of the impact force.

To open the cabinet, the gear is rotated reversely to drive the latch 91 to rotate and detach from the latch bracket 92. At the same time, the gear drives the two connecting rod pieces 42 to move closer to each other. Each locking piece 30 is detached from the corresponding first groove and second groove. In addition, the first pulley slides out of the first slot, and the second pulley slides out of the second slot. In this way, the cabinet is opened smoothly.

Finally, it is hereby noted that the foregoing embodiments are merely intended to describe the technical solutions of this application but not to limit this application. Although this application has been described in detail with reference to the foregoing embodiments, a person of ordinary skill in the art understands that modifications may still be made to the technical solutions described in the foregoing embodiments, or equivalent replacements may still be made to some or all technical features in the technical solutions. Such modifications and equivalent replacements fall within the scope of the claims and specification hereof without making the essence of the corresponding technical solutions depart from the scope of the technical solutions of the embodiments of this application. Particularly, to the extent that no structural conflict exists, various technical features mentioned in different embodiments may be combined in any manner. This application is not limited to the specific embodiments disclosed herein, but includes all technical solutions falling within the scope of the claims.

## Claims

1. A connection assembly, configured to implement connection to open or close a cabinet, wherein the cabinet comprises a cabinet body and a door, and the connection assembly comprises:
a first limiting piece, fixed onto the door;
a second limiting piece, fixed onto the cabinet body, wherein the second limiting piece is disposed opposite to the first limiting piece; and
a locking piece, wherein the locking piece is configured to be fitted into the first limiting piece and the second limiting piece when the cabinet is closed.

2. The connection assembly according to claim 1, wherein a first locking position is created on the first limiting piece, a second locking position is created on the second limiting piece, and, when the cabinet is closed, the locking piece fits into the first locking position and the second locking position.

3. The connection assembly according to claim 2, wherein the first locking position is configured to be a first groove, and/or the second locking position is configured to be a second groove.

4. The connection assembly according to claim 3, wherein the first locking position is configured to be the first groove, the second locking position is configured to be the second groove, and the second groove and the first groove open in a same direction.

5. The connection assembly according to claim 4, wherein two first grooves are provided, and openings of the two first grooves are opposite to each other in a height direction of the cabinet.

6. The connection assembly according to claim 4 or 5, wherein two second grooves are provided, and openings of the two second grooves are opposite to each other in a height direction of the cabinet.

7. The connection assembly according to claim 4, wherein a plurality of the first limiting pieces are provided, the first groove is created on each first limiting piece, and openings of at least two of the first grooves are opposite to each other in a height direction of the cabinet.

8. The connection assembly according to claim 4 or 7, wherein a plurality of the second limiting pieces are provided, the second groove is created on each second limiting piece, and openings of at least two of the second grooves are opposite to each other in a height direction of the cabinet.

9. The connection assembly according to any one of claims 1 to 8, wherein the connection assembly comprises a connecting rod assembly extending along a height direction of the cabinet, and the connecting rod assembly is configured to connect the door and the first limiting piece.

10. The connection assembly according to claim 9, wherein the connecting rod assembly comprises a connecting rod base and two connecting rod pieces disposed on the door, the two connecting rod pieces are connected to two opposite sides of the connecting rod base respectively along the height direction of the cabinet, and the connecting rod base is configured to drive the two connecting rod pieces to move closer to or away from each other.

11. The connection assembly according to claim 10, wherein a plurality of the first limiting pieces are provided, and a first groove is created on each first limiting piece; and
the first grooves on the first limiting pieces located on a same side of the connecting rod base along the height direction of the cabinet open in a same direction, and all the first grooves open toward the connecting rod base.

12. The connection assembly according to claim 10 or 11, wherein a plurality of the second limiting pieces are provided, and a second groove is created on each second limiting piece; and
the second grooves on the second limiting pieces located on a same side of the connecting rod base along the height direction of the cabinet open in a same direction, and all the second grooves open toward the connecting rod base.

13. The connection assembly according to any one of claims 10 to 12, wherein the locking piece is a limiting pin, the limiting pin is disposed protrusively on the connecting rod piece, and the limiting pin intersects the connecting rod piece.

14. The connection assembly according to any one of claims 10 to 13, wherein the connection assembly further comprises a bracket fixed onto the door, and the connecting rod piece penetrates and fits into the bracket.

15. The connection assembly according to any one of claims 9 to 14, wherein the connection assembly further comprises a slide piece disposed on the connecting rod assembly and a mating piece disposed on the door, and, when the connecting rod assembly moves along an extension direction of the connecting rod assembly, the slide piece is able to slide into or out of the mating piece.

16. The connection assembly according to claim 15, wherein the slide piece is configured to be a pulley, and the mating piece is configured to be a slot that mates with the pulley.

17. The connection assembly according to claim 16, wherein at least a part of a wall of the slot is configured to be a guide surface, and the guide surface is configured to guide the pulley to slide into or out of the slot.

18. The connection assembly according to any one of claims 1 to 17, wherein the connection assembly further comprises a latch disposed on the door and a latch bracket disposed on the cabinet body and mated to the latch, and, when the cabinet is closed, the latch is connected to the latch bracket.

19. An energy storage cabinet, comprising:
a cabinet body;
a door, rotatably disposed on the cabinet; and
the connection assembly according to any one of claims 1 to 18, wherein the connection assembly is connected between the door and the cabinet body.

20. An energy storage system, comprising a battery, a control device, and the energy storage cabinet according to claim 19, wherein the battery is accommodated in the energy storage cabinet, and the control device is electrically connected to the battery.
